# EUROPEAN PATENT SPECIFICATION

(11) **EP 4 035 897 B1**
(45) Date of publication and mention of the grant of the patent: **09.12.2026**
(21) Application number: 21153964.8
(22) Date of filing: 28.01.2021
(51) Int. Cl.: B41C 1/10

(54) **A LITHOGRAPHIC PRINTING PLATE PRECURSOR**
LITHOGRAFIEDRUCKPLATTENVORLÄUFER
PRÉCURSEUR DE PLAQUE D'IMPRESSION LITHOGRAPHIQUE

(43) Date of publication of application: 03.08.2022
(73) Proprietor: ECO3 BV, 2640 Mortsel (BE)
(72) Inventor: BILLIET, Thomas, 2640 Mortsel (BE); HEYLEN, Kristof, 2640 Mortsel (BE)
(74) Representative: De Clercq & Partners

(56) References cited:
- EP-A1- 3 587 113
- EP-A1- 3 674 096
- EP-B1- 2 855 153
- EBCONT COMMUNICATIONS OLIVER ET AL: "Polyvinylidenchlorid - RÖMPP, Thieme", 1 December 2009 (2009-12-01), XP093225667, Retrieved from the Internet <URL:https://roempp.thieme.de/lexicon/RD-16-03660?searchterm=pvdc&context=search> [retrieved on 20241119]

## Description

### Technical Field

The invention relates to a novel lithographic printing plate precursor.

### Background Art

Lithographic printing typically involves the use of a so-called printing master such as a printing plate which is mounted on a cylinder of a rotary printing press. The master carries a lithographic image on its surface and a print is obtained by applying ink to said image and then transferring the ink from the master onto a receiver material, which is typically paper. In conventional lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

Lithographic printing masters are generally obtained by the image-wise exposure and processing of a radiation sensitive layer on a lithographic support. Imaging and processing renders the so-called lithographic printing plate precursor into a printing plate or master. Image-wise exposure of the radiation sensitive coating to heat or light, typically by means of a digitally modulated exposure device such as a laser, triggers a physical and/or chemical process, such as ablation, polymerization, insolubilization by cross-linking of a polymer or by particle coagulation of a thermoplastic polymer latex, solubilization by the destruction of intermolecular interactions or by increasing the penetrability of a development barrier layer. Although some plate precursors are capable of producing a lithographic image immediately after exposure, the most popular lithographic plate precursors require wet processing since the exposure produces a difference in solubility or difference in rate of dissolution in a developer between the exposed and the non-exposed areas of the coating. In positive working lithographic plate precursors, the exposed areas of the coating dissolve in the developer while the non-exposed areas remain resistant to the developer. In negative-working lithographic plate precursors, the non-exposed areas of the coating dissolve in the developer while the exposed areas remain resistant to the developer. Most lithographic plate precursors contain a hydrophobic coating on a hydrophilic support, so that the areas which remain resistant to the developer define the ink-accepting, hence printing areas of the plate while the hydrophilic support is revealed by the dissolution of the coating in the developer at the non-printing areas.

Photopolymer printing plates rely on a working-mechanism whereby the coating - which typically includes free radically polymerisable compounds - hardens upon exposure. "Hardens" means that the coating becomes insoluble or non-dispersible in the developing solution and may be achieved through polymerization and/or crosslinking of the photosensitive coating upon exposure to light and/or heat. Photopolymer plate precursors can be sensitized to blue, green or red light i.e. wavelengths ranging between 450 and 750 nm, to violet light i.e. wavelengths ranging between 300 and 450 nm or to infrared light i.e. wavelengths ranging between 750 and 1500 nm. Optionally, the exposure step is followed by a heating step to enhance or to speed-up the polymerization and/or crosslinking reaction.

In general, a toplayer or protective overcoat layer over the imageable layer is required to act as an oxygen barrier to provide the desired sensitivity to the plate. A toplayer typically includes water-soluble or water-swellable polymers such as for example polyvinylalcohol and/or copolymers thereof. Besides acting as barrier for oxygen, the toplayer should best be easily removable during processing and be sufficiently transparent for actinic radiation, e.g. from 300 to 450 nm or from 450 to 750 nm or from 750 to 1500 nm.

A printing plate precursor which contains a coating comprising at least two layers of which the toplayer includes a hydrophobic binder is disclosed in EP 3 587 112 and EP 3 587 113.

The classical workflow of photopolymer plates involves first an exposure step of the photopolymer printing plate precursor in a violet or infrared platesetter, followed by an optional pre-heat step, a wash step of the protective overcoat layer, an alkaline developing step, and a rinse and gum step. However, there is a clear evolution in the direction of a simplified workflow where the pre-heat step and/or wash step are eliminated and where the processing and gumming step are carried out in one single step or where processing is carried out with a neutral gum and then gummed in a second step. Alternatively, on-press processing wherein the plate is mounted on the press and the coating layer is developed by interaction with the fountain and/or ink that are supplied to the plate during the press run, has become very popular. During the first runs of the press, the non-image areas are removed from the support and thereby define the non-printing areas of the plate.

In a typical industrial plate making process, printing plate precursors are after coating susceptible to damages caused by mechanical forces applied to the surface of the plate precursors during automatic transport, mechanical handling and/or manual handling. After coating and drying printing plates are stacked and are then, by means of specified packaging equipment, cut, packed in boxes and transported. During cutting and packing of the printing plate precursors as well as during transport of the packed printing plate precursors, the plates may move relatively to each other whereby the coating is rubbed which often results in surface damage. These surface damages in the image recording layer often produce visible defects in the image areas of the coating. Moreover, the manual handling of the printing plate precursors may result in so-called fingerprints which also leads to a reduced printing quality.

In the art, it has been proposed to overcome the above mentioned problems by adding for example organic waxes to the coating. EP 2 855 153 discloses a negative-working printing plate including an imageable layer and a water-soluble overcoat layer comprising one or more film-forming water-soluble polymeric binders and organic wax particles having an average largest dimension of at least 0.05 to 0.7 µm. EP 2 962 157 discloses a negative-working printing plate including an imageable layer and a water-soluble overcoat layer which includes two different types of particles, organic wax particles and non-wax particles having specified sizes. EP 3 674 096 discloses a lithographic printing plate precursor including an overcoat layer including a water-soluble polymer and particles having a melting point in a range of 70°C to 150°C and a volume average particle diameter greater than 0.7 mm. EP 3 677 434 discloses a lithographic printing plate precursor comprising an image recording layer and an outermost layer including projections which are discontinuously formed and have a melting point in a range of 70°C to 150°C.

However, although the printing plates of the prior art described above may be less susceptible to damages provoked during automatic transport, addition of a wax typically reduces the static friction coefficient leading to difficulties in plate stacking and transportation. Therefore, it is desired to have a plate which has good mechanical handling and/or manual handling properties, without becoming too slippery.

### Summary of invention

It is therefore an object of the present invention to provide a negative-working printing plate precursor based on photopolymerisation which not only possesses an excellent scratch resistance but which is less susceptible to plate movements relative to each other during mechanical handling and/or manual handling, and/or during automatic transport.

This object is realised by the printing plate precursor defined in claim 1 with preferred embodiments defined in the dependent claims. The printing plate precursor of the present invention has the specific feature that it contains a coating comprising at least two layers of which the toplayer includes a hydrophobic binder and hydrophobic discrete particles.

It was surprisingly found that the printing plates according to the present invention display a superior scratch resistance while at the same time the risk of movements of the printing plate precursors relative to each other when for example stacked and/or transported is minimized. Moreover, the toplayer comprising a hydrophobic binder and hydrophobic discrete particles substantially improves the clean out behaviour of the plate during start-up of the print job and minimize press contamination. More specific, fountain solutions become less contaminated during printing and consequently allow for printing with a reduced consumption of fountain solution.

Startup of a print job refers to the number of prints needed to have a complete disappearance of toning present on the paper prints.

Other features, elements, steps, characteristics and advantages of the present invention will become more apparent from the following detailed description of preferred embodiments of the present invention. Specific embodiments of the invention are also defined in the dependent claims.

### Description of embodiments

The lithographic printing plate precursor

The lithographic printing plate precursor according to the present invention is negative-working, i.e. after exposure and development the non-exposed areas of the coating are removed from the support and define hydrophilic (non-printing) areas, whereas the exposed coating is not removed from the support and defines oleophilic (printing) areas. The hydrophilic areas are defined by the support which has a hydrophilic surface or is provided with a hydrophilic layer. The hydrophobic areas are defined by the coating, hardened upon exposing, optionally followed by a heating step. Areas having hydrophilic properties means areas having a higher affinity for an aqueous solution than for an (oleophilic) ink; areas having hydrophobic properties means areas having a higher affinity for an (oleophilic) ink than for an aqueous solution.

"Hardened" means that the coating becomes insoluble or non-dispersible for the developing solution and may be achieved through polymerization and/or crosslinking of the photosensitive coating, optionally followed by a heating step to enhance or to speed-up the polymerization and/or crosslinking reaction. In this optional heating step, hereinafter also referred to as "pre-heat", the plate precursor is heated, preferably at a temperature of about 80°C to 150°C and preferably during a dwell time of about 5 seconds to 1 minute.

The coating contains a toplayer and at least one layer including a photopolymerisable composition, said layer is also referred to as the "photopolymerisable layer". The toplayer is provided on top of the photopolymerisable layer. The coating may further include other layers such as for example an intermediate layer, located between the support and the photopolymerisable layer and/or between the top layer and the photopolymerisable layer, an adhesion improving layer, a hydrophilizing layer and/or other layers.

The printing plate of the present invention is characterized in that it can be exposed at a low energy density, i.e. below 190 mJ/m²; preferably between 70 and 190 mJ/m²; more preferably between 75 and 150 mJ/m² and most preferably between 80 and 120 mJ/m².

### Toplayer

The coating includes a toplayer or protective overcoat layer which acts as an oxygen barrier layer. Low molecular weight substances present in the air may deteriorate or even inhibit image formation and therefore a toplayer is applied to the coating. A toplayer should preferably be easily removable during development, adhere sufficiently to the photopolymerisable layer or optional other layers of the coating and should preferably not inhibit the transmission of light during exposure. The toplayer is provided on top of the photopolymerisable layer.

### The hydrophobic binder

The toplayer includes a hydrophobic polymer, also referred to as the "hydrophobic binder". A hydrophobic polymer is a polymer which is preferably not soluble or swellable in water - i.e. at about neutral pH. The hydrophobic binder is preferably not cross-linked or only slightly cross-linked. The hydrophobic polymer may be in the form of powder or particles, preferably the binder is in the form of particles. The hydrophobic polymer is preferably used in the form of a dispersion; i.e. an emulsion or suspension. Preferred is a dispersion of particles in an aqueous medium.

The average particle size is preferably comprised between 10 nm and 1000 nm, more preferably between 25 nm and 250 nm, even more preferably between 30 nm and 200 nm and most preferably between 50 nm and 175 nm. Herein, the particle size is defined as the particle diameter, measured by Photon Correlation Spectrometry, also known as Quasi-Elastic or Dynamic Light-Scattering. This technique is a convenient method for measuring the particle size and the values of the measured particle size match well with the particle size measured with transmission electronic microscopy (TEM) as disclosed by Stanley D. Duke et al. in Calibration of Spherical Particles by Light Scattering, in Technical Note-002B, May 15, 2000 (revised 1/3/2000 from a paper published in Particulate Science and Technology 7, p. 223-228 (1989).

The hydrophobic binder preferably has a minimum film forming temperature (MFFT) below 25°C, more preferably below 20°C and most preferably below 15°C. The MMFT is defined as the minimum temperature at which particles may preferably uniformly coalesce when applied on a surface in the form of a thin film.

The amount of the hydrophobic binder in the toplayer is preferably between 40%wt and 96%wt, more preferably between 45%wt and 90%wt and most preferably between 55%wt and 85%wt; relative to the total weight of the overcoat layer. The hydrophobic binder preferably has at least one Tg value between 0°C and 60°C.

The hydrophobic binder preferably includes at least one monomeric unit derived from vinyl and/or vinylidene monomer; preferably vinylidene monomers. The hydrophobic binder may be a homopolymer or a copolymer. Copolymers are highly preferred. The copolymer is preferably a random copolymer, a gradient copolymer or a segmented copolymer. The segmented copolymer is preferably a block copolymer, a graft copolymer or a star polymer in which polymer chains are bonded to a core. Suitable examples of vinyl monomers include vinyl halides such as vinyl chloride, vinyl bromide or vinyl iodide. Suitable examples of vinylidene monomers include a halogen such as fluoride, chloride, bromide or iodide, i.e. vinylidene halides such as vinylidene fluoride, vinylidene chloride, vinylidene bromide or vinylidene iodide.

In a highly preferred embodiment, the hydrophobic binder includes at least one monomeric unit derived from a vinylidene monomer and is referred to herein as PVDC binder. Suitable vinylidene monomers include vinylidene halides such as vinylidene fluoride, vinylidene chloride, vinylidene bromide and/or vinylidene iodide. Most preferably the hydrophobic binder includes at least one monomeric unit derived from vinylidene fluoride and/or vinylidene chloride, most preferably from vinylidene chloride. The hydrophobic binder preferably includes between 60 %wt and 95 %wt monomeric units derived from vinylidene monomers, more preferably between 65%wt and 90%wt and most preferably between 70 and 85%wt.

The hydrophobic binder can be synthesized by conventionally known methods based on addition polymerisation. The numeric average molecular weight (Mn) of the polymers used in the present invention ranges preferably from 5.000 g/mol to 1.000.000 g/mol, more preferably from 10.000 g/mol to 500.000 g/mol and most preferably from 20.000 g/mol to 150.000 g/mol. The weight average molecular weight (Mw) of the polymers used in the present invention ranges preferably from 10.000 g/mol to 400.000 g/mol, more preferably from 70.000 g/mol to 350.000 g/mol and most preferably from 100.000 g/mol to 250.000 g/mol. The numeric average molecular weight (Mn) and the weight average molecular weight (Mw) are each determined by size exclusion chromatography using a mixture of THF and 5%wt acetic acid as eluent and polystyrene as calibration standards.

The hydrophobic binder used in the present invention is preferably a copolymer such as a gradient copolymer which exhibits a gradual change in monomer composition from predominantly one monomer to predominantly the other; or a random copolymer which has no continuous change in composition. The hydrophobic binder may comprise other monomeric units besides vinyl and/or vinylidene monomeric units as defined above. The hydrophobic binder preferably includes between 5 %wt and 40 %wt of these other monomeric units, more preferably between 10 %wt and 30 %wt and most preferably between 15%wt and 25%wt. All amounts of the monomeric unities, expressed herein as %wt, refer to the sum of all monomeric units of the copolymer.

The hydrophobic binder may further comprise one or more other monomeric units preferably derived from acrylate or methacrylate e.g. an alkyl or aryl (meth)acrylate such as methyl (meth)acrylate, ethyl (meth)acrylate, butyl (meth)acrylate, benzyl (meth)acrylate, 2-phenylethyl (meth)acrylate, hydroxylethyl (meth)acrylate, phenyl (meth)acrylate or N-(4-metylpyridyl)(meth)acrylate; (meth)acrylic acid; a (meth)acrylamide e.g. (meth)acrylamide or a N-alkyl or N-aryl (meth)acrylamide such as N-methyl (meth)acrylamide, N-ethyl (meth)acrylamide, N-phenyl (meth)acrylamide, N-benzyl (meth)acrylamide, N-methylol (meth)acrylamide, N-(4-hydroxyphenyl)(meth)acrylamide; (meth)acrylonitrile; styrene; a substituted styrene such as 2-, 3- or 4-hydroxy-styrene, 4-carboxy-styrene ester; a vinylpyridine such as 2-vinylpyridine, 3-vinylpyridine, 4-vinylpyridine; a substituted vinylpyridine such as 4-methyl-2-vinylpyridine; vinyl acetate, optionally the copolymerised vinyl acetate monomeric units are at least partially hydrolysed, forming an alcohol group, and/or at least partially reacted by an aldehyde compound such as formaldehyde or butyraldehyde, forming an acetal or butyral group; vinyl alcohol; vinyl nitrile; vinyl acetal; vinyl butyral; a vinyl ether such as methyl vinyl ether; vinyl amide; a N-alkyl vinyl amide such as N-methyl vinyl amide, caprolactame, vinyl pyrrolydone; maleic anhydride, a maleimide e.g. maleimide or a N-alkyl or N-aryl maleimide such as N-benzyl maleimide.

In a preferred embodiment, the binder further comprises monomeric units selected from (meth)acrylates such as methyl (meth)acrylate, ethyl(meth)acrylate, propyl (meth)acrylate, butyl(meth)acrylate or phenyl(meth)acrylate, hydroxyethyl (meth)acrylate or benzyl (meth)acrylate; vinyl nitrile or vinyl pyrrolidone.

The hydrophobic binder most preferably includes methyl acrylate units and/or butyl acrylate units.

Particularly preferred PVDC polymers are IxanTM and DiofanTM commercially available from Solvay, PVDC latex commercially available from Asahi-Kasei, DaranTM commercially available from Owensboro, PermaxTM commercially available from Lubrizol. Some of these copolymer grades are not waterbased but can be dispersed in water via different dispersion techniques well-known in the art in order to obtain a water based dispersion.

The toplayer may include other binder(s) besides the hydrophobic binder. Preferred binders which can be used in the top layer are disclosed in WO2005/029190 (page 36 line 3 to page 39 line 25), US 2007/0020563 (paragraph [0158]) and EP 1 288 720 (paragraphs [0148] and [0149]). Most preferred binders which can be used in the toplayer are polyvinylalcohol or polyvinylalcohol/polyvinyl acetate copolymers. This copolymer preferably has a hydrolysis degree ranging between 74 mol % and 99 mol %, more preferably between 80-98%. The weight average molecular weight of the polyvinylalcohol can be defined by measuring the viscosity of an aqueous solution, 4 % by weight, at 20°C as defined in DIN 53 015, and this viscosity number (mPas) ranges preferably between 2 and 26, more preferably between 2 and 15, most preferably between 2 and 10. Modified polyvinylalcohols or polyvinylalcohol/polyvinyl acetate copolymers, e.g. polyvinylalcohols or copolymers including a carboxyl group and/or a sulphonic acid group may also be used, preferably together with unmodified polyvinylalcohols or polyvinylalcohol/polyvinyl acetate copolymers.

### The hydrophobic discrete particles

The toplayer further includes hydrophobic discrete particles. The hydrophobic discrete particles have a melting and/or softening temperature above 50°C, preferably above 60°C and more preferably above 80° C and most preferably above 100° C; the hydrophobic discrete particles are also referred to herein as "hydrophobic wax particles".

The hydrophobic discrete particles are preferably finely dispersed in a liquid carrier such as water or organic solvent(s), preferably water such as emulsions or dispersions. Preferred is a dispersion of particles in an aqueous medium. To produce an emulsion, the molten hydrophobic particles are mixed with hot water and an emulsifier. In the case of hydrophobic particles with a melting point above 100 ° C, this emulsification is carried out under pressure.

The hydrophobic discrete particles comprise optionally substituted hydrocarbon compounds including 15 to 50 carbon atoms, more preferably between 20 and 40 carbon atoms. Hydrocarbon compounds are selected from low density polyethylene, high density polyethylene, polypropylene, polytetrafluoroethylene, and/or mixtures thereof.

The hydrophobic discrete particles preferably have an average largest dimension of 1 µm or below 1 µm, more preferably below 0.5 µm and most preferably below 0.1 µm. The particle size refers to the average particle size and may be measured by a laser diffraction particle analyzer such as the Coulter LS Particle Size Analyzer, e.g. the Coulter LS-230, commercially available by Beckman Coulter Inc. The average particle size is defined as the mean or median of the volume distribution of particle size.

By adding the hydrophobic discrete particles to the toplayer its resistance against manual or mechanical damage is further improved. The hydrophobic discrete particles preferably have a diameter, which is smaller than the thickness of the toplayer. The toplayer preferably has a layer thickness comprised between 0.10 and 1.75 g/m² more preferably between 0.20 and 1.3 g/m², most preferably between 0.25 and 1.0 g/m².

The amount of the hydrophobic discrete particles in the toplayer is preferably comprised between between 0.5 %wt and 10 %wt; relative to the total weight of the toplayer.

The static friction coefficient of the toplayer is preferably higher than 45, more preferably higher than 55.

### Other ingredients

The toplayer may optionally include other ingredients such as inorganic or organic acids, matting agents, surfactants such as anionic surfactants, e.g. sodium alkyl sulphate or sodium alkyl sulphonate; amphoteric surfactants, e.g. alkylaminocarboxylate and alkylamino-dicarboxylate; non-ionic surfactants, e.g. polyoxyethylene alkyl phenyl ether, fillers, (organic) waxes, alkoxylated alkylene diamines as for example disclosed in EP 1 085 380 (paragraph [0021] and [0022]), glycerine, inorganic particles, pigments or wetting agents as disclosed in EP 2 916 171.

The toplayer may further includes a leuco dye which forms a coloured compound upon exposure to UV light, infrared light and/or heat whereby a print-out image is formed. The contrast of the print-out image may be defined as the difference between the optical density at the exposed area to the optical density at the non-exposed area, and is preferably as high as possible. This enables the end-user to establish immediately whether or not the precursor has already been exposed and processed, to distinguish the different color selections and to inspect the quality of the image on the plate precursor. The contrast of the print-out image preferably increases with increasing optical density in the exposed areas and can be measured in reflectance using an optical densitometer, equipped with several filters (e.g. cyan, magenta, yellow).

All publicly-known leuco dyes can be used and are not restricted. They are for example widely used in conventional photosensitive or thermally-sensitive recording materials. For more information about leuco dyes, see for example Chemistry and Applications of Leuco Dyes, Ramaiah Muthyala, Plenum Press, 1997.

A number of classes of leuco dyes may be used as colour forming compounds in the present invention, such as for example: spiropyran leuco dyes such as spirobenzopyrans (e.g. spiroindolinobenzopyrans, spirobenzo-pyranobenzopyrans, 2,2-dialkylchromenes), spironaphtooxazine and spirothiopyran; leuco quinone dyes; azines such as oxazines, diazines, thiazines and phenazine; phthalide- and phthalimidine-type leuco dyes such as triarylmethane phtalides (e.g. crystal violet lactone), diarylmethane phthalides, monoarylmethane phthalides, heterocyclic substituted phthalides, alkenyl substituted phthalides, bridged phthalides (e.g. spirofluorene phthalides and spirobenzanthracene phthalides) and bisphthalides; fluoran leuco dyes such as fluoresceins, rhodamines and rhodols; triarylmethanes such as leuco crystal violet; ketazines; barbituric acid leuco dyes and thiobarbituric acid leuco dyes.

The leuco dye is preferably present in the toplayer in an amount of 0.01 to 0.1 g/m², more preferably in an amount of 0.02 to 0.08 g/m², most preferably in an amount of 0.025 to 0.05 g/m².

Preferred IR-leuco dyes are leuco dyes which have a main absorption in the infrared wavelength range of the electromagnetic spectrum - i.e. a wavelength range between about 750 and 1500nm - and does preferably not have a substantial light absorption in the visible wavelength range of the electromagnetic spectrum - i.e. a wavelength range between 390 and 700nm. Preferred IR-leuco dyes are disclosed in EP 1 736 312 and have a partial structure according to the following formula: 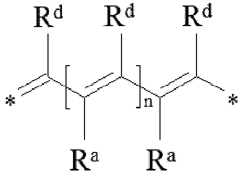 wherein * denotes links of the partial structure to the rest of the structure and wherein at least one of the R^{d} groups is a group which is transformed by a chemical reaction, induced by exposure to IR radiation or heat, into a group which is a stronger electron-donor than said R^{d}; or wherein at least one of the R^{a} groups is a group which is transformed by a chemical reaction, induced by exposure to IR-radiation or heat, into a group which is a stronger electron acceptor than said R^{a}. An electron accepting group is preferably defined as having a Hammett sigma para-value more than or equal to 0.3 and an electron donor group as having a Hammett sigma para-value less than or equal to 0.3. Details concerning sigma para-values can be found in Chapman and Shorter, Correlation Analysis in Chemistry, Recent Advances, Plenum, New York, 1978, p.439-540.

The concentration of the IR-Leuco dye with respect to the total dry weight of the coating, may be from 0.1 %wt to 20.0 %wt, more preferably from 0.5 %wt to 15.0 %wt, most preferred from 1.0 %wt to 10.0 %wt. More details regarding these IR-Leuco dyes are described in EP 3 587 112 [0028] to [0060] .

### Definitions

An aliphatic hydrocarbon group preferably represents an alkyl, cycloalkyl, alkenyl, cyclo alkenyl or alkynyl group; suitable groups thereof are described below. An aromatic hydrocarbon group preferably represents a hetero(aryl) group; suitable hetero(aryl) groups - i.e. suitable aryl or heteroaryl groups - are described below.

The term "alkyl" herein means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc. Examples of suitable alkyl groups are methyl, ethyl, n-propyl, isopropyl, n-butyl, 1-isobutyl, 2-isobutyl and tertiary-butyl, n-pentyl, n-hexyl, chloromethyl, trichloromethyl, iso-propyl, iso-butyl, iso-pentyl, neo-pentyl, 1-methylbutyl and iso-hexyl, 1,1-dimethyl-propyl, 2,2-dimethylpropyl and 2-methyl-butyl, cyclopropyl, cyclobutyl, cyclopentyl, cyclohexyl and methylcyclohexyl groups. Preferably, the alkyl group is a C₁ to C₆-alkyl group.

A suitable alkenyl group is preferably a C₂ to C₆-alkenyl group such as an ethenyl, n-propenyl, n-butenyl, n-pentenyl, n-hexenyl, iso-propenyl, isobutenyl, iso-pentenyl, neo-pentenyl, 1-methylbutenyl, iso-hexenyl, cyclopentenyl, cyclohexenyl and methylcyclohexenyl group.

A suitable alkynyl group is preferably a C₂ to C₆-alkynyl group; a suitable aralkyl group is preferably a phenyl group or naphthyl group including one, two, three or more C₁ to C₆-alkyl groups; a suitable alkaryl group is preferably a C₁ to C₆-alkyl group including an aryl group, preferably a phenyl group or naphthyl group.

A cyclic group or cyclic structure includes at least one ring structure and may be a monocyclic- or polycyclic group, meaning one or more rings fused together.

Examples of suitable aryl groups may be represented by for example an optionally substituted phenyl, benzyl, tolyl or an ortho- meta- or para-xylyl group, an optionally substituted naphtyl, anthracenyl, phenanthrenyl, and/or combinations thereof. The heteroaryl group is preferably a monocyclic or polycyclic aromatic ring comprising carbon atoms and one or more heteroatoms in the ring structure, preferably, 1 to 4 heteroatoms, independently selected from nitrogen, oxygen, selenium and sulphur. Preferred examples thereof include an optionally substituted furyl, pyridinyl, pyrimidyl, pyrazoyl, imidazoyl, oxazoyl, isoxazoyl, thienyl, tetrazoyl, thiazoyl, (1,2,3)triazoyl, (1,2,4)triazoyl, thiadiazoyl, thiofenyl group and/or combinations thereof.

A cyclic group or cyclic structure includes at least one ring structure and may be a monocyclic- or polycyclic group, meaning one or more rings fused together.

Halogens are selected from fluorine, chlorine, bromine or iodine.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms.

The optional substituents on the alkyl, cycloalkyl, alkenyl, cycloalkenyl, alkynyl, aralkyl, alkaryl, hydrocarbon, aryl and heteroaryl group are preferably selected from hydroxy, -Cl, -Br, -I, -OH, -SH, -CN, -NO₂, an alkyl group such as a methyl or ethyl group, an alkoxy group such as a methoxy or an ethoxy group, an aryloxy group, a carboxylic acid group or an alkyl ester thereof, a sulphonic acid group or an alkyl ester thereof, a phosphonic acid group or an alkyl ester thereof, a phosphoric acid group or an an ester such as an alkyl ester such as methyl ester or ethyl ester, a thioalkyl group, a thioaryl group, thioheteroaryl, -SH, a thioether such as a thioalkyl or thioaryl, ketone, aldehyde, sulfoxide, sulfone, sulfonate ester, sulphonamide, an amino, ethenyl, alkenyl, alkynyl, cycloalkyl, alkaryl, aralkyl, aryl, heteroaryl or heteroalicyclic group and/or combinations thereof.

The term leuco dye refers to a compound which can change from essentially colourless or pale-coloured to coloured, or vice versa, when irradiated with UV light, IR light and/or heated.

### Support

The lithographic printing plate used in the present invention comprises a support which has a hydrophilic surface or which is provided with a hydrophilic layer. The support is preferably a grained and anodized aluminium support, well known in the art. Suitable supports are for example disclosed in EP 1 843 203 (paragraphs [0066] to [0075]). The surface roughness, obtained after the graining step, is often expressed as arithmetical mean center-line roughness Ra (ISO 4287/1 or DIN 4762) and may vary between 0.05 and 1.5 µm. The aluminum substrate of the current invention has preferably an Ra value between 0.1 and 1.4 µm, more preferably between 0.3 and 1.0 µm and most preferably between 0.4 and 0.9 µm. The lower limit of the Ra value is preferably about 0.1 µm. More details concerning the preferred Ra values of the surface of the grained and anodized aluminum support are described in EP 1 356 926. By anodising the aluminum support, an Al₂O₃ layer is formed and the anodic weight (g/m² Al₂O₃ formed on the aluminum surface) varies between 1 and 8 g/m². The anodic weight is preferably ≥ 2.0 g/m², more preferably ≥ 2.5 g/m² and most preferably ≥ 3.0 g/m²

The grained and anodized aluminium support may be subjected to so-called post-anodic treatments, for example a treatment with polyvinylphosphonic acid or derivatives thereof, a treatment with polyacrylic acid or derivatives thereof, a treatment with potassium fluorozirconate or a phosphate, a treatment with an alkali metal silicate, or combinations thereof. Treatment of the edges of the support as described in for example US 2017/320351 may be of interest to prevent occurrence of printing edges. Alternatively, the support may be treated with an adhesion promoting compound such as those described in EP 1 788 434 in [0010] and in WO 2013/182328. However, for a precursor optimized to be used without a pre-heat step it is preferred to use a grained and anodized aluminium support without any post-anodic treatment.

Besides an aluminium support, a plastic support, for example a polyester support, provided with one or more hydrophilic layers as disclosed in for example EP 1 025 992 may also be used.

### Photopolymer coating

### Photopolymerisable compound

The coating has at least one layer including a photopolymerisable composition, said layer is also referred to as the "photopolymerisable layer". The coating may include an intermediate layer, located between the support and the photopolymerisable layer.

The photopolymerisable layer includes at least one polymerisable compound and optionally a binder. The photopolymerisable layer has a coating thickness preferably ranging between 0.2 and 5.0 g/m², more preferably between 0.4 and 3.0 g/m², most preferably between 0.6 and 2.2 g/m².

According to a preferred embodiment of the present invention, the polymerisable compound is a polymerisable monomer or oligomer including at least one terminal ethylenic unsaturated group, hereinafter also referred to as "free-radical polymerisable monomer". The polymerisation involves the linking together of the free-radical polymerisable monomers. Suitable free-radical polymerisable monomers include, for example, multifunctional (meth)acrylate monomers (such as (meth)acrylate esters of ethylene glycol, trimethylolpropane, pentaerythritol, ethylene glycol, ethoxylated trimethylolpropane, urethane (meth)acrylate) and oligomeric amine diacrylates. The (meth)acrylic monomers may also have other ethylenically unsaturated groups or epoxide groups in addition to the (meth)acrylate group. The (meth)acrylate monomers may also contain an acidic (such as a carboxylic acid or phosphoric acid) or basic (such as an amine) functionality.

Suitable free-radical polymerisable monomers are disclosed in [0042] and [0050] of EP 2 916 171.

### The initiator

Any free radical initiator capable of generating free radicals upon exposure directly or in the presence of a sensitizer, is according to this invention a suitable initiator. Suitable examples of initiators include onium salts, carbon-halogen bond-containing compounds such as [1,3,5] triazines having trihalomethyl groups, organic peroxides, aromatic ketones, thio compounds, azo based polymerization initiators, azide compounds, ketooxime esters, hexaarylbisimidazoles, metallocenes, active ester compounds, borates and quinonediazides. Of these, onium salts, especially iodonium and/or sulfonium salts are preferable in view of storage stability.

More specific suitable free-radical initiators include, for example, the derivatives of acetophenone (such as 2,2-dimethoxy-2-phenylacetophenone, and 2-methyl-1-[4-(methylthio)phenyll-2-morpholino propan-l-one); benzophenone; benzil; ketocoumarin (such as 3-benzoyl-7-methoxy coumarin and 7-methoxy coumarin); xanthone; thioxanthone; benzoin or an alkyl-substituted anthraquinone; onium salts (such as diaryliodonium hexafluoroantimonate, diaryliodonium triflate, (4-(2-hydroxytetradecyl-oxy)-phenyl) phenyliodonium hexafluoroantimonate, triarylsulfonium hexafluorophosphate, triarylsulfonium p-toluenesulfonate, (3-phenylpropan-2-onyl) triaryl phosphonium hexafluoroantimonate, and N-ethoxy(2-methyl)pyridinium hexafluorophosphate, and onium salts as described in U.S. Pat.Nos. 5,955,238,6,037,098, and 5,629,354); borate salts (such as tetrabutylammonium triphenyl(n-butyl)borate, tetraethylammonium triphenyl(n-butyl)borate, diphenyliodonium tetraphenylborate, and triphenylsulfonium triphenyl(n-butyl)borate, and borate salts as described in U.S. Pat. Nos. 6,232,038 and 6,218,076,); haloalkyl substituted s-triazines (such as 2,4-bis(trichloromethyl)-6-(p-methoxy-styryl)-s-triazine, 2,4-bis(trichloromethyl)-6-(4-methoxy-naphth-l-yl)-s-triazine, 2,4-bis(trichloromethyl)-6-piperonyl-s- triazine, and 2,4-bis(trichloromethyl)-6-[(4 -ethoxy-ethylenoxy)-phen-1-yl]-s-triazine, and s-triazines as described in U.S. Pat. Nos. 5,955,238, 6,037,098, 6,010,824 and 5,629,354); and titanocene (bis(etha.9-2,4-cyclopentadien-1-yl) bis[2,6-difluoro-3-(IH-pyrrol-1-yl)phenyl) titanium). Onium salts, borate salts, and s-triazines are preferred free radical initiators. Diaryliodonium salts and triarylsulfonium salts are preferred onium salts. Triarylalkylborate salts are preferred borate salts. Trichloromethyl substituted s-triazines are preferred s-triazines. These initiators may be used alone or in combination.

Optionally substituted trihaloalkyl sulfones wherein halo independently represents bromo, chloro or iodo and sulfone is a chemical compound containing a sulfonyl functional group attached to two carbon atoms, are particularly preferred initiators. Tribromomethyl phenyl sulfones are most preferred initiators. More details concerning this initiator can be found in unpublished copending application EP 18163285.2 paragraphs [0029] to [0040] .

The amount of the initiator typically ranges from 0.1 to 30 % by weight, preferably from 0.5 to 15 % by weight, most preferably from 2 to 10 % by weight relative to the total weight of the non volatile components of the photopolymerisable composition.

A very high sensitivity can be obtained by the combination of an optical brightener as sensitizer and a polymerisation initiator.

The photopolymerisable layer may also comprise a co-initiator. Typically, a co-initiator is used in combination with a free radical initiator. Suitable co-initiators for use in the photopolymer coating are disclosed in US 6,410,205; US 5,049,479; EP 1 079 276, EP 1 369 232, EP 1 369 231, EP 1 341 040, US 2003/0124460, EP 1 241 002, EP 1 288 720 and in the reference book including the cited refences: Chemistry & Technology UV & EB formulation for coatings, inks & paints - Volume 3 - Photoinitiators for Free Radical and Cationic Polymerisation by K.K. Dietliker - Edited by P.K.T. Oldring - 1991 - ISBN 0 947798161. Specific co-initiators, as described in EP 107 792, may be present in the photopolymerizable layer to further increase the sensitivity. Preferred co-initiators are disclosed in EP 2 916 171 [0051]

A very high sensitivity can be obtained by including a sensitizer such as for example an optical brightener in the coating. Suitable examples of optical brighteners as sensitizers are described in WO 2005/109103 page 24, line 20 to page 39. Useful sensitizers can be selected from the sensitizing dyes disclosed in US 6,410,205; US 5,049,479; EP 1 079 276, EP 1 369 232, EP 1 369 231, EP 1 341 040, US 2003/0124460, EP 1 241 002 and EP 1 288 720.

Specific co-initiators, as described in EP 107 792, may be present in the photopolymerizable layer to further increase the sensitivity. Preferred co-initiators are sulfur-compounds, especially thiols like e.g. 2-mercaptobenzothiazole, 2-mercaptobenzoxazole, 2-mercaptobenzimidazole, 4-methyl-3-propyl-1,2,4-triazoline-5-thione, 4-methyl-3-n-heptyl-1,2,4-triazoline-5-thione, 4-phenyl-3-n-heptyl-1,2,4-triazoline-5-thione, 4-phenyl-3,5-dimercapto-1,2,4-triazole, 4-n-decyl-3,5-dimercapto-1,2,4-triazole, 5-phenyl-2-mercapto-1,3,4-oxadiazole, 5-methylthio-1,3,4-thiadiazoline-2-thione, 5-hexylthio-1,3,4-thiadiazoline-2-thione, mercaptophenyltetrazole, pentaerythritol mercaptopropionate, butyric acid-3-mercapto-neopentanetetrayl ester, pentaerythritol tetra(thioglycolate). Other preferred co-initiators are polythioles as disclosed in WO 2006/048443 and WO 2006/048445. These polythiols may be used in combination with the above described thiols, e.g. 2-mercaptobenzothiazole.

The photopolymerizable layer may optionally include violet or infrared light absorbing dyes as sensitizers. Infrared light absorbing dyes absorb light between 750 nm and 1300 nm, preferably between 780 nm and 1200 nm, more preferably between 800 nm and 1100 nm. Particular preferred sensitizers are heptamethinecyanine dyes disclosed in EP 1 359 008 paragraph [0030] to [0032].

### The binder

The photopolymerizable layer preferably includes a binder. The binder can be selected from a wide series of organic polymers. Compositions of different binders can also be used. Useful binders are described in for example EP 1 043 627 in paragraph [0013], WO2005/111727 page 17 line 21 to page 19 line 30 and in WO2005/029187 page 16 line 26 to page 18 line 11.

The PVDC binder as described above may also be present in the photopolymerizable layer.

The photopolymerizable layer may include discrete particles, i.e. particulate shaped polymers including homopolymers or copolymers prepared from monomers such as ethylene, styrene, vinyl chloride, methyl acrylate, ethyl acrylate, methyl methacrylate, ethyl methacrylate, acrylonitrile, vinyl carbazole, acrylate or methacrylate, or mixtures thereof. Preferably the discrete particles are particles which are suspended in the polymerisable composition. The presence of discrete particles tends to promote developability of the unexposed areas.

Thermally reactive polymer fine particles including a thermally reactive group such as an ethylenically unsaturated group, a cationic polymerizable group, an isocyanate group, an epoxy group, a vinyloxy group, and a functional group having an active hydrogen atom, a carboxy group, a hydroxy group, an amino group or an acid anhydride.

Specific examples of the polymeric binders according to this embodiment are described in US 6,899,994; US 2004/0260050, US 2005/0003285, US 2005/0170286, US 2005/0123853 and EP 2 916 171 in [0029], [0030] and [0031] . Other suitable binders as described in EP 2 471 655, EP 2 492 748 and EP 2 660 068 include multifunctional thiols having 6 to 10 functional groups as a nucleus (central skeleton) and polymer chains connected to the nucleus through sulfide bonds. In addition to the polymeric binder of this embodiment the imageable layer may optionally comprise one or more co-binders. Typical co-binders are water-soluble or water-dispersible polymers, such as, cellulose derivatives, polyvinylalcohol, polyacrylic acid poly(meth)acrylic acid, polyvinylpyrrolidone, polylactide, polyvinylphosphonic acid, synthetic co-polymers, such as co-polymers of an alkoxy polyethylene glycol (meth)acrylate. Specific examples of co-binders are described in US 2004/0260050, US 2005/0003285 and US 2005/0123853. Printing plate precursors, the imageable layer of which comprises a binder and optionally a co-binder according this embodiment and described in more detail in US 2004/0260050, US 2005/0003285 and US 2005/0123853.

The average particle diameter of the polymer fine particle is preferably 0.01 mm to 3.0 mm. Particulate polymers in the form of microcapsules, microgels or reactive microgels are suitable as disclosed in EP 1 132 200; EP 1 724 112 and US 2004/106060.

### Other ingredients

The photopolymerisable layer may also comprise particles which increase the resistance of the coating against manual or mechanical damage. The particles may be inorganic particles, organic particles or fillers such as described in for example US 7,108,956. More details of suitable spacer particles are described in EP 2 916 171 [0053] to [0056].

The photopolymerizable layer may also comprise an inhibitor. Particular inhibitors for use in the photopolymer coating are disclosed in US 6,410,205, EP 1 288 720 and EP 1 749 240.

The photopolymerizable layer may further comprise an adhesion promoting compound. The adhesion promoting compound is a compound capable of interacting with the support, preferably a compound having an addition-polymerizable ethylenically unsaturated bond and a functional group capable of interacting with the support. Under "interacting" is understood each type of physical and/or chemical reaction or process whereby, between the functional group and the support, a bond is formed which can be a covalent bond, an ionic bond, a complex bond, a coordinate bond or a hydrogen-bond, and which can be formed by an adsorption process, a chemical reaction, an acid-base reaction, a complex-forming reaction or a reaction of a chelating group or a ligand. The adhesion promoting compounds are described in EP 2 916 171 [0058].

Various surfactants may be added into the photopolymerisable layer to allow or enhance the developability of the precursor; especially developing with a gum solution. Both polymeric and small molecule surfactants for example nonionic surfactants are preferred. More details are described in EP 2 916 171 [0059].

### Exposure step

The printing plate precursor is preferably image-wise exposed by a laser emitting IR light. Preferably, the image-wise exposing step is carried out off-press in a platesetter, i.e. an exposure apparatus suitable for image-wise exposing the precursor with a laser such as a laser diode, emitting around 830 nm or a Nd YAG laser emitting around 1060 nm, a violet laser, emitting around 400 nm, or a gas laser such as an Ar laser, or with a digitally modulated UV-exposure set-up, using e.g. digital mirror devices, or by a conventional exposure in contact with a mask. In a preferred embodiment of the present invention, the precursor is image-wise exposed by a laser emitting IR light or violet light, more preferably by a laser emitting IR light.

### Preheat step

After the exposing step, the precursor may be pre-heated in a preheating unit, preferably at a temperature of about 80°C to 150°C and preferably during a dwell time of about 5 seconds to 1 minute. This preheating unit may comprise a heating element, preferably an IR-lamp, an UV-lamp, heated air or a heated roll. Such a preheat step can be used for printing plate precursors comprising a photopolymerisable composition to enhance or to speed-up the polymerization and/or crosslinking reaction.

### Development step

Subsequently to the exposing step or the preheat step, when a preheat step is present, the plate precursor may be processed (developed). Before developing the imaged precursor, a pre-rinse step might be carried out especially for the negative-working lithographic printing precursors having a protective oxygen barrier or topcoat. This pre-rinse step can be carried out in a stand-alone apparatus or by manually rinsing the imaged precursor with water or the pre-rinse step can be carried out in a washing unit that is integrated in a processor used for developing the imaged precursor. The washing liquid is preferably water, more preferably tap water. More details concerning the wash step are described in EP 1 788 434 in [0026].

During the development step, the non-exposed areas of the image-recording layer are at least partially removed without essentially removing the exposed areas. The processing liquid, also referred to as developer, can be applied to the plate e.g. by rubbing with an impregnated pad, by dipping, immersing, coating, spincoating, spraying, pouring-on, either by hand or in an automatic processing apparatus. The treatment with a processing liquid may be combined with mechanical rubbing, e.g. by a rotating brush. During the development step, any water-soluble protective layer present is preferably also removed. The development is preferably carried out at temperatures between 20 and 40 °C in automated processing units.

In a highly preferred embodiment, the processing step as described above is replaced by an on-press processing whereby the imaged precursor is mounted on a press and processed on-press by rotating said plate cylinder while feeding dampening liquid and/or ink to the coating of the precursor to remove the unexposed areas from the support. In a preferred embodiment, supply of dampening liquid and ink is started simultaneously, or only ink can be supplied during a number of revolutions before switching on the supply of dampening liquid. In an alternative embodiment, only dampening liquid is supplied to the plate during start-up of the press and after a number of revolutions of the plate cylinder also the ink supply is switched on.

The processing step may also be performed by combining embodiments described above, e.g. combining development with a processing liquid with development on-press by applying ink and/or fountain.

### Processing liquid

The processing liquid may be an alkaline developer or solvent-based developer. Suitable alkaline developers have been described in US2005/0162505. An alkaline developer is an aqueous solution which has a pH of at least 11, more typically at least 12, preferably from 12 to 14. Alkaline developers typically contain alkaline agents to obtain high pH values can be inorganic or organic alkaline agents. The developers can comprise anionic, non-ionic and amphoteric surfactants (up to 3% on the total composition weight); biocides (antimicrobial and/or antifungal agents), antifoaming agents or chelating agents (such as alkali gluconates), and thickening agents (water soluble or water dispersible polyhydroxy compounds such as glycerine or polyethylene glycol).

Preferably, the processing liquid is a gum solution whereby during the development step the non-exposed areas of the photopolymerisable layer are removed from the support and the plate is gummed in a single step. The development with a gum solution has the additional benefit that, due to the remaining gum on the plate in the non-exposed areas, an additional gumming step is not required to protect the surface of the support in the non-printing areas. As a result, the precursor is processed and gummed in one single step which involves a less complex developing apparatus than a developing apparatus comprising a developer tank, a rinsing section and a gumming section. The gumming section may comprise at least one gumming unit or may comprise two or more gumming units. These gumming units may have the configuration of a cascade system, i.e. the gum solution, used in the second gumming unit and present in the second tank, overflows from the second tank to the first tank when gum replenishing solution is added in the second gumming unit or when the gum solution in the second gumming unit is used once-only, i.e. only starting gum solution is used to develop the precursor in this second gumming unit by preferably a spraying or jetting technique. More details concerning such gum development is described in EP1 788 444.

A gum solution is typically an aqueous liquid which comprises one or more surface protective compounds that are capable of protecting the lithographic image of a printing plate against contamination, e.g. by oxidation, fingerprints, fats, oils or dust, or damaging, e.g. by scratches during handling of the plate. Suitable examples of such surface protective compounds are film-forming hydrophilic polymers or surfactants. The layer that remains on the plate after treatment with the gum solution preferably comprises between 0.005 and 20 g/m² of the surface protective compound, more preferably between 0.010 and 10 g/m², most preferably between 0.020 and 5 g/m². More details concerning the surface protective compounds in the gum solution can be found in WO 2007/057348 page 9 line 3 to page 11 line 6. As the developed plate precursor is developed and gummed in one step, there is no need to post-treat the processed plate.

The gum solution preferably has a pH value between 3 and 11, more preferably between 4 and 10, even more preferably between 5 and 9, and most preferably between 6 and 8. A suitable gum solution is described in for example EP 1 342 568 in [0008] to [0022] and WO2005/111727. The gum solution may further comprise an inorganic salt, an anionic surfactant, a wetting agent, a chelate compound, an antiseptic compound, an antifoaming compound and/or an ink receptivity agent and/or combinations thereof. More details about these additional ingredients are described in WO 2007/057348 page 11 line 22 to page 14 line 19.

### Drying and baking step

After the processing step the plate is dried in a drying unit. In a preferred embodiment the plate is dried by heating the plate in the drying unit which may contain at least one heating element selected from an IR-lamp, an UV-lamp, a heated metal roller or heated air.

The drying temperature is preferably between 50° and 100°; more preferably between 55° and 90° and most preferably between 60° and 80°.

After drying the plate can optionally be heated in a baking unit. More details concerning the heating in a baking unit can be found in WO 2007/057348 page 44 line 26 to page 45 line 20.

According to the present invention there is also provided a method for making a negative-working lithographic printing plate comprising the steps of imagewise exposing a printing plate precursor followed by developing the imagewise exposed precursor so that the non-exposed areas are dissolved in the developer solution. The development is preferably carried out by treating the precursor with a gum solution, however more preferably by mounting the precursor on a plate cylinder of a lithographic printing press and rotating the plate cylinder while feeding dampening liquid and/or ink to the precursor. Optionally, after the imaging step, a heating step is carried out to enhance or to speed-up the polymerization and/or crosslinking reaction. The lithographic printing plate precursor can be prepared by (i) applying on a support the coating as described above and (ii) drying the precursor. Any coating method can be used for applying one or more coating solutions to the hydrophilic surface of the support. The multi-layer coating can be applied by coating/drying each layer consecutively or by the simultaneous coating of several coating solutions at once. In the drying step, the volatile solvents are removed from the coating until the coating is self-supporting and dry to the touch.

The printing plate thus obtained can be used for conventional, so-called wet offset printing, in which ink and an aqueous dampening liquid is supplied to the plate. Another suitable printing method uses a so-called single-fluid ink without a dampening liquid. Suitable single-fluid inks have been described in US 4,045,232; US 4,981,517 and US 6,140,392. In a most preferred embodiment, the single-fluid ink comprises an ink phase, also called the hydrophobic or oleophilic phase, and a polyol phase as described in WO 00/32705.

### EXAMPLES

### Example 1

### Preparation of the aluminium support S-01

A 0.3 mm thick aluminium foil was degreased by spraying with an aqueous solution containing 26 g/l NaOH at 65°C for 2 seconds and rinsed with demineralised water for 1.5 seconds. The foil was then electrochemically grained during 10 seconds using an alternating current in an aqueous solution containing 15 g/l HCl, 15 g/l SO4²⁻ ions and 5 g/l Al³⁺ ions at a temperature of 37°C and a current density of about 100 A/dm². Afterwards, the aluminium foil was then desmutted by etching with an aqueous solution containing 5.5 g/l of NaOH at 36°C for 2 seconds and rinsed with demineralised water for 2 seconds. The foil was subsequently subjected to anodic oxidation during 15 seconds in an aqueous solution containing 145 g/l of sulfuric acid at a temperature of 50°C and a current density of 17 A/dm², then washed with demineralised water for 11 seconds and dried at 120°C for 5 seconds.

### Preparation of comparative printing plates PP-01 to PP-03 and inventive printing plates PP-04 and PP-05

### Photopolymerizable layer

The photopolymerizable layers PL-01 and PL-02 including the components as defined in Table 1, were dissolved in a mixture of 35% by volume of MEK and 65% by volume of Dowanol PM (1-methoxy-2-propanol, commercially available from DOW CHEMICAL Company) and coated onto the above described support S-01. The coating solution was applied at a wet coating thickness of 30 µm and then dried at 120°C for 1 minute in a circulation oven.

**Table 1: Composition of photopolymerizable layers PL-01 and PL-02**

| **INGREDIENTS mg/m²** | **PL-01** | **PL-02** |
|---|---|---|
| FST 510 (1) | 250 | 250 |
| CN 104 (2) | 250 | 250 |
| Ini-01 (3) | 60 | 60 |
| Sodium tetraphenylborate | 20 | 20 |
| IR-01 (4) | 20 | 20 |
| GN-169 (5) | 25 | - |
| Ruco coat EC4811 (6) | 125 | 125 |
| S LEC BL10 (7) | 125 | 125 |
| Tegoglide 410 (8) | 1.5 | 1.5 |
| JPA 528 (9) | 130 | 130 |
| Belclene 400 (10) | 15 | 15 |
| Aerosil 150 (11) | 85 | 85 |

| | | |
|---|---|---|
| (1) FST 510 is a reaction product from 1 mole of 2,2,4-trimethylhexamethylenediisocyanate and 2 moles of hydroxyethyl-methacrylate commercially available from AZ. Electronics as a 82 wt.% solution in MEK; (2) CN 104 is an epoxy acrylate oligomer commercially available from Arkema; (3) Ini-01 is 4-hydroxyphenyl-tribromomethyl-sulfone; 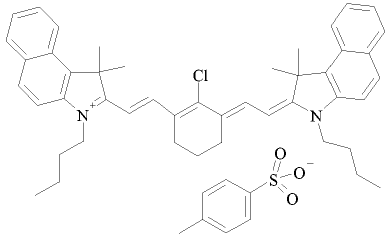 (4) IR-01 is an infrared absorbing compound represented by the following structure: (5) GN-169 is a color forming compound commercially available from Mitsui Chemicals Europe GmbH; (6) Ruco Coat EC4811 is a non-ionic aliphatic polyether polyurethane commercially available from Rudolf GmbH; (7) SLEC BL10 is poly(vinylbutyral-co-vinylacetate-co-vinylalcohol) commercially available from Sekisui Chemical Co., Ltd; (8) Tegoglide 410 is a polyether siloxane copolymer commercially available from Evonik Resource Efficiency GmbH; (9) JPA 528 is a polyethylene glycol monomethacrylate acid phosphate commercially available from Johoku Chemical Co., Ltd; (10) Belclene 400 is a phosphinocarboxylic acid commercially available from BWA Water Additives UK Ltd; (11) Aerosil 150 is a hydrophilic fumed silica commercially available from Evonik Resource Efficiency GmbH. | | |

### Protective overcoat layer

On top of the photosensitive layer, a solution in water with the composition as defined in Table 2 was coated (40 µm wet film), and dried at 110°C for 2 minutes.

**Table 2: Composition of protective overcoat layers**

| **INGREDIENTS mg/m²** | **OC-01** | **OC-02** | **OC-03** | **OC-04** | **OC-05** |
|---|---|---|---|---|---|
| Mowiol 4-88 (1) | 309 | 309 | 80 | 80 | 80 |
| Mowiol 4-98 (2) | 186 | 186 | - | - | - |
| Mowiol 28-99 (2) | - | - | 80 | 80 | 80 |
| Diofan A050 (3) | - | - | 296 | 296 | 296 |
| Acticide LA1206 (4) | 1 | 1 | 1 | 1 | 1 |
| Lutensol A8 (5) | 10 | 10 | 10 | 10 | 10 |
| Aquacer 537 (6) | - | 20 | - | 6.5 | 20 |
| Luviskol K30 (7) | 40 | 40 | - | - | - |
| IR-02 (8) | - | - | 29 | 29 | 29 |

| | | | | | |
|---|---|---|---|---|---|
| (1) Mowiol 4-88TM is a partially hydrolyzed polyvinylalcohol commercially available from Kuraray; (2) Mowiol 4-98TM and Mowiol 28-99 are fully hydrolyzed polyvinylalcohols commercially available from Kuraray; (3) Diofan A050 is a polyvinylidene chloride latex commercially available from Solvay; (4) Acticide LA1206TM is a biocide commercially available from Thor; (5) Lutensol A8TM is a surface active agent commercially available from BASF; (6) Aquacer 537 is an anionic emulsion based on a modified paraffin wax having a melting point of 110°C, commercially available from BYK; (7) Luviskol K30TM is a polyvinylpyrolidone homopolymer commercially available from BASF; (8) IR-02 is an infrared absorbing dye having the following formula: 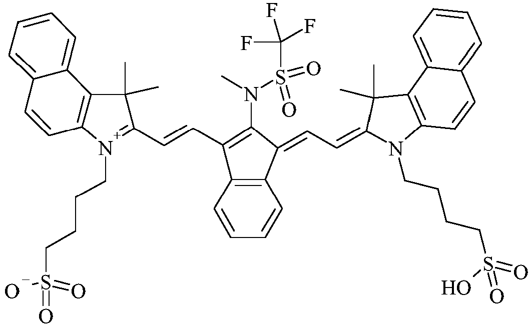 | | | | | |

**Table 3: Comparative printing plate precursors PPP-01 to PPP-03 and inventive printing plates PPP-04 and PPP-05**

| **Printing plate precursor** | **PL** | **OC** |
|---|---|---|
| PPP-01 *comparative* | PL-01 | OC-01 |
| PPP-02 *comparative* | PL-01 | OC-02 |
| PPP-03 *comparative* | PL-02 | OC-03 |
| PPP-04 *inventive* | PL-02 | OC-04 |
| PPP-05 *inventive* | PL-02 | OC-05 |

### Imaging

The printing plate precursors were subsequently imaged at 2400 dpi with a High Power Creo 40W TE38 thermal platesetterTM (200 lpi Agfa Balanced Screening (ABS)), commercially available from Kodak and equipped with a 830 nm IR laser diode, at energy density of 130 mJ/cm².

### Scratch resistance test

A test setup for evaluation of the scratch sensitivity of the printing plate precursors was set up as follows.

The printing plate precursor was placed on a vacuum table to keep the sample fixed in position upon switching on the vacuum. A range of loads was brought into contact with the printing plate precursor and during contact moved across the surface of the plate under constant speed. Each load was equipped with a spherical ball contact point (diameter 3 mm, type 901R, commercially available from MAHR). Calibrated weights of 50-100-200-300-400-500-600-700-800-900-1000-1200 grams were used as loads in the scratch experiment.

Subsequently, the printing plate precursors were mounted on a Heidelberg GTO 52 printing press. Each print job was started using K+E Skinnex 800 SPEED IK black ink (trademark of BASF Druckfarben GmbH) and 4 wt% Prima FS303 SF (trademark of Agfa Graphics) and 8% isopropanol in water as fountain solution. A compressible blanket was used and printing was performed on non-coated offset paper.

Prior to paper feeding, 10 press revolutions with only the dampening system engaged followed by 5 revolutions with the inking rollers engaged was performed.

Printing plates PP-01 to PP-05 were obtained and all plates showed good development on press.

Visual assessment of the printed sheets was performed to evaluate toning (i.e. accepting ink) in the non-image areas. Sheet 250 was used to assess the scratch sensitivity in the non-image areas. A scratch is observed as an ink accepting line on the printed sheet in the non image areas. The width of the printed line for each load is measured and scored accordingly:
0 : no ink accepting line observed on page 250
1 : an ink accepting line having a width up to 100µm
2 : an ink accepting line having a width between 100µm and 150µm
3 : an ink accepting line having a width between 150µm and 200µm
4 : an ink accepting line having a width > 200µm

The scores for each load obtained as described above were added up to give one general score: i.e. the average scratch sensitivity value. The average scratch sensitivity values as well as the lowest load at which a scratch is obtained are summarized in Table 4 below.

### Static friction coefficient

The static friction coefficient of the printing plate precursors PP-01 to PP-05 were measured according to ISO8295:1995 using a friction apparatus FYS at an equilibrated temperature of 22°C (± 1°C) and a relative humidity of 50% (± 2%). The printing plate precursors were preconditioned at least 4 hours prior to the measurement. Five repetitive measurements of the static friction coefficient was performed against interleaving paper using a load of 235 grams and the obtained results were averaged.

The results of the average static friction coefficient are summarized in Table 4.

**Table 4: Results of the scratch resistance test and static friction coefficient**

| **Printing plate** | **Wax mg/m2** | **PVDC particles** | **Minimum load*** | **Average scratch sensitivity value** | **Static friction coefficient**** |
|---|---|---|---|---|---|
| PP-01 *Comparative* | 0 | no | 600 g | 12 | 0.50 |
| PP-02 *Comparative* | 20 | no | 1000 g | 5 | 0.42 |
| PP-03 *Comparative* | 0 | yes | 400 g | 18 | 0.60 |
| PP-04 *Inventive* | 6.5 | yes | 1200 g | 4 | 0.58 |
| PP-05 *Inventive* | 20 | yes | - | 0 | 0.62 |

| | | | | | |
|---|---|---|---|---|---|
| *Minimum load at which scratches start to show ** measured on the printing plate precursors | | | | | |

The results in Table 4 show:
*Average scratch sensitivity value*
   - The comparative printing plates without wax in the protective overcoat layer (PP-01 and PP-03) demonstrate a significant higher average scratch sensitivity value (12 and 18) compared to the printing plates containing wax in the protective overcoat layer (PP-02, PP-04 and PP-05).
   - The inventive printing plate precursor PP-04 including only a low amount of wax and further including PVDC in the protective overcoat layer, shows an average scratch sensitivity value which is comparable (even slightly lower) with the comparative printing plate precursor PP-02 including a high amount of wax but no PVDC particles in the protective overcoat.
   - The inventive printing plate precursor PP-05 including besides a high amount of wax also PVDC particles in the protective overcoat layer, shows no scratch formation throughout the entire scratch resistance test.
*Minimum load*
   - The scratch formation of the comparative printing plates PP-01 and PP-02 already start at loads of only 600g and 400 g respectively.
   - The inventive printing plate PP-04 starts to show scratch formation at a minimum load of 1200 g while the comparative printing plate PP-02 at the lower weight of 1000 g.
*Static friction coefficient*
   - The static friction coefficient of the inventive printing plates PP-04 and PP-05 containing wax in the protective overcoat layer remains about stable compared to the comparative printing plate PP-03 containing no wax in the protective overcoat layer. A stable (and high) static friction coefficient will reduce the risk of plate shifting upon stacking and transportation.
   - The static friction coefficient of the comparative printing plates PP-01 and PP-02 containing no PVDC particles in the overcoat significantly reduces when wax is present (PP-02 versus PP-01) resulting in undesirable slippery plates.

## Claims

1. A negative-working lithographic printing plate precursor including a support and a coating comprising (i) a photopolymerisable layer including a polymerisable compound and a photoinitiator, and a toplayer including a hydrophobic binder provided above the photopolymerisable layer;
**characterized in that** the toplayer further includes hydrophobic discrete particles having a melting and/or softening temperature above 50° C, and wherein said hydrophobic discrete particles comprise optionally substituted hydrocarbon compounds including 15 to 50 carbon atoms, and being selected from low density polyethylene, high density polyethylene, polypropylene, polytetrafluoroethylene, and/or mixtures thereof .

2. The lithographic printing plate precursor according to claim 1 wherein the hydrophobic discrete particles have a melting and/or softening temperature above 80° C.

3. The printing plate precursor according to claims 1 or 2 wherein the hydrophobic binder has a minimum film forming temperature below 25° C.

4. The printing plate precursor according to claims 1 or 2 wherein the hydrophobic binder has a minimum film forming temperature below 20° C.

5. The printing plate precursor according to any of the preceding claims wherein the hydrophobic binder is present in the toplayer in an amount between 40%wt and 96%wt relative to the total weight of the toplayer.

6. The printing plate precursor according to any of the preceding claims wherein the hydrophobic binder includes a monomeric unit derived from a vinyl monomer and/or a vinylidene monomer.

7. The lithographic printing plate precursor according to any of the preceding claims wherein the hydrophobic discrete particles are selected from hydrocarbon compounds containing between 20 and 40 carbon atoms.

8. The lithographic printing plate precursor according to any of the preceding claims wherein the hydrophobic discrete particles are selected from low density polyethylene, high density polyethylene and/or mixtures thereof.

9. The lithographic printing plate precursor according to any of the preceding claims wherein the static friction coefficient of the toplayer is higher than 45.

10. The lithographic printing plate precursor according to any of the preceding claims wherein the hydrophobic discrete particles are present in an amount between 0.5 %wt and 10 %wt relative to the total weight of the toplayer.

11. The lithographic printing plate precursor according to any of the preceding claims wherein the coating is on-press developable.

12. A method for making a negative-working printing plate precursor including the step of
- coating on a support (i) a photopolymerisable layer including a polymerisable compound and a photoinitiator, and (ii) a toplayer as defined in any of the preceding claims provided above the photopolymerisable layer,
- drying the precursor.

13. The method according to claim 12 wherein the lithographic printing plate precursor is proccesable on-press.

14. A method for making a negative-working printing plate including the steps of
- image-wise exposing the printing plate precursor as defined in any of the preceding claims to heat and/or light radiation whereby a lithographic image consisting of image areas and non-image areas is formed,
- developing the exposed precursor.

15. The method according to claim 14 wherein the precursor is developed by mounting the precursor on a plate cylinder of a lithographic printing press and rotating the plate cylinder while feeding dampening liquid and/or ink to the precursor.

## Patentansprüche

1. Negativ arbeitender Lithographie-Druckplattenvorläufer, der einen Träger und eine Beschichtung aufweist, die (i) eine photopolymerisierbare Schicht, die eine polymerisierbare Verbindung und einen Photoinitiator enthält, und eine Deckschicht, die ein hydrophobes Bindemittel enthält, die über der photopolymerisierbaren Schicht bereitgestellt ist, umfasst;
**dadurch gekennzeichnet, dass** die Deckschicht ferner hydrophobe diskrete Partikel mit einer Schmelz- und/oder Erweichungstemperatur über 50 °C enthält, und wobei die hydrophoben diskreten Partikel gegebenenfalls substituierte Kohlenwasserstoffverbindungen mit 15 bis 50 Kohlenstoffatomen umfassen und ausgewählt sind aus Polyethylen niedriger Dichte, Polyethylen hoher Dichte, Polypropylen, Polytetrafluorethylen und/oder Gemischen davon.

2. Lithographie-Druckplattenvorläufer nach Anspruch 1, wobei die hydrophoben diskreten Partikel eine Schmelz- und/oder Erweichungstemperatur über 80 °C aufweisen.

3. Druckplattenvorläufer nach Anspruch 1 oder 2, wobei das hydrophobe Bindemittel eine Mindest-Filmbildungstemperatur unter 25 °C aufweist.

4. Druckplattenvorläufer nach Anspruch 1 oder 2, wobei das hydrophobe Bindemittel eine Mindest-Filmbildungstemperatur unter 20 °C aufweist.

5. Druckplattenvorläufer nach einem der vorstehenden Ansprüche, wobei das hydrophobe Bindemittel in der Deckschicht in einer Menge zwischen 40 Gew.-% und 96 Gew.-% bezogen auf das Gesamtgewicht der Deckschicht vorhanden ist.

6. Druckplattenvorläufer nach einem der vorstehenden Ansprüche, wobei das hydrophobe Bindemittel eine Monomereinheit abgeleitet von einem Vinylmonomer und/oder einem Vinylidenmonomer umfasst.

7. Lithographie-Druckplattenvorläufer nach einem der vorstehenden Ansprüche, wobei die hydrophoben diskreten Partikel aus Kohlenwasserstoffverbindungen mit zwischen 20 und 40 Kohlenstoffatomen ausgewählt sind.

8. Lithographie-Druckplattenvorläufer nach einem der vorstehenden Ansprüche, wobei die hydrophoben diskreten Partikel ausgewählt sind aus Polyethylen niedriger Dichte, Polyethylen hoher Dichte und/oder Gemischen davon.

9. Lithographie-Druckplattenvorläufer nach einem der vorstehenden Ansprüche, wobei der Haftreibungskoeffizient der Deckschicht höher als 45 ist.

10. Lithographie-Druckplattenvorläufer nach einem der vorstehenden Ansprüche, wobei die hydrophoben diskreten Partikel in einer Menge zwischen 0,5 Gew.- % und 10 Gew.- % bezogen auf das Gesamtgewicht der Deckschicht vorhanden sind.

11. Lithographie-Druckplattenvorläufer nach einem der vorstehenden Ansprüche, wobei die Beschichtung auf der Druckmaschine entwickelbar ist.

12. Verfahren zur Herstellung eines negativ arbeitenden Druckplattenvorläufers, umfassend den Schritt
- Aufschichten (i) einer photopolymerisierbaren Schicht, die eine polymerisierbare Verbindung und einen Photoinitiator enthält, und (ii) einer Deckschicht, wie in einem der vorstehenden Ansprüche definiert, die über der photopolymerisierbaren Schicht bereitgestellt ist, auf einen Träger,
- Trocknen des Vorläufers.

13. Verfahren nach Anspruch 12, wobei der Lithographie-Druckplattenvorläufer auf der Druckmaschine verarbeitbar ist.

14. Verfahren zur Herstellung einer negativ arbeitenden Druckplatte, umfassend die Schritte
- bildweises Exponieren des Druckplattenvorläufers nach einem der vorstehenden Ansprüche gegenüber Wärme und/oder Lichtstrahlung, wodurch ein lithographisches Bild, das aus Bildbereichen und Nichtbildbereichen besteht, gebildet wird,
- Entwickeln des exponierten Vorläufers.

15. Verfahren nach Anspruch 14, wobei der Vorläufer entwickelt wird, indem der Vorläufer auf einem Plattenzylinder einer lithographischen Druckmaschine montiert wird und der Plattenzylinder gedreht wird, während dem Vorläufer Feuchtflüssigkeit und/oder Tinte zugeführt wird.

## Revendications

1. Précurseur de plaque d'impression lithographique travaillant en négatif comprenant un support et un revêtement comprenant (i) une couche photopolymérisable comprenant un composé polymérisable et un photoinitiateur, et une couche supérieure comprenant un liant hydrophobe disposée au-dessus de la couche photopolymérisable ;
**caractérisé en ce que** la couche supérieure comprend en outre des particules discrètes hydrophobes ayant une température de fusion et/ou de ramollissement supérieure à 50 °C, et dans lequel lesdites particules discrètes hydrophobes comprennent des composés hydrocarbonés éventuellement substitués comprenant 15 à 50 atomes de carbone, et étant choisies parmi le polyéthylène basse densité, le polyéthylène haute densité, le polypropylène, le polytétrafluoroéthylène et/ou les mélanges correspondants.

2. Précurseur de plaque d'impression lithographique selon la revendication 1, dans lequel les particules discrètes hydrophobes ont une température de fusion et/ou de ramollissement supérieure à 80 °C.

3. Précurseur de plaque d'impression selon la revendication 1 ou 2, dans lequel le liant hydrophobe a une température minimale de formation de film inférieure à 25 °C.

4. Précurseur de plaque d'impression selon la revendication 1 ou 2, dans lequel le liant hydrophobe a une température minimale de formation de film inférieure à 20 °C.

5. Précurseur de plaque d'impression selon l'une quelconque des revendications précédentes, dans lequel le liant hydrophobe est présent dans la couche supérieure en une quantité comprise entre 40 % en poids et 96 % en poids par rapport au poids total de la couche supérieure.

6. Précurseur de plaque d'impression selon l'une quelconque des revendications précédentes, dans lequel le liant hydrophobe comprend un motif monomérique dérivé d'un monomère vinylique et/ou d'un monomère de vinylidène.

7. Précurseur de plaque d'impression lithographique selon l'une quelconque des revendications précédentes, dans lequel les particules discrètes hydrophobes sont choisies parmi les composés hydrocarbonés contenant entre 20 et 40 atomes de carbone.

8. Précurseur de plaque d'impression lithographique selon l'une quelconque des revendications précédentes, dans lequel les particules discrètes hydrophobes sont choisies parmi le polyéthylène basse densité, le polyéthylène haute densité et/ou les mélanges correspondants.

9. Précurseur de plaque d'impression lithographique selon l'une quelconque des revendications précédentes, dans lequel le coefficient de frottement statique de la couche supérieure est supérieur à 45.

10. Précurseur de plaque d'impression lithographique selon l'une quelconque des revendications précédentes, dans lequel les particules discrètes hydrophobes sont présentes en une quantité comprise entre 0,5 % en poids et 10 % en poids par rapport au poids total de la couche supérieure.

11. Précurseur de plaque d'impression lithographique selon l'une quelconque des revendications précédentes, dans lequel le revêtement est développable sur presse.

12. Procédé de fabrication d'un précurseur de plaque d'impression travaillant en négatif comprenant l'étape de
- revêtement sur un support (i) d'une couche photopolymérisable comprenant un composé polymérisable et un photoinitiateur, et (ii) d'une couche supérieure telle que définie selon l'une quelconque des revendications précédentes disposée au-dessus de la couche photopolymérisable,
- séchage du précurseur.

13. Procédé selon la revendication 12, dans lequel le précurseur de plaque d'impression lithographique peut être traité sur presse.

14. Procédé de fabrication d'une plaque d'impression travaillant en négatif comprenant les étapes de
- exposition en forme d'image du précurseur de plaque d'impression tel que défini dans l'une quelconque des revendications précédentes à de la chaleur et/ou un rayonnement lumineux, moyennant quoi une image lithographique constituée de zones d'image et de zones de non-image est formée,
- développement du précurseur exposé.

15. Procédé selon la revendication 14, dans lequel le précurseur est développé en montant le précurseur sur un cylindre porte-plaque d'une presse d'impression lithographique et en faisant tourner le cylindre porte-plaque tout en acheminant un liquide de mouillage et/ou une encre vers le précurseur.
